# EUROPEAN PATENT APPLICATION

(11) **EP 4 791 156 A1**
(43) Date of publication of application: **12.08.2026**
(21) Application number: 26151269.3
(22) Date of filing: 12.01.2026
(51) Int. Cl.: H10H 29/01, H10H 29/30, H10H 29/853

(54) **DISPLAY DEVICE AND MANUFACTURING METHOD THEREOF**

(30) Priority: 05.02.2025 US 202563753966 P; 09.10.2025 CN 202511437540
(71) Applicant: Innolux Corporation, Jhunan Town, Miaoli County 35053 (TW)
(72) Inventor: TSAI, Yi-Cheng, 35053 Jhunan Town, Miaoli County (TW); TSAI, Chia-Hao, 35053 Jhunan Town, Miaoli County (TW); WU, Yung-Hsun, 35053 Jhunan Town, Miaoli County (TW)
(74) Representative: Becker, Eberhard

(57) **Abstract**

A display device comprises a substrate, a circuit layer, a plurality of light-emitting elements, and an encapsulation layer is provided. The circuit layer is disposed on the substrate. The plurality of light-emitting elements are disposed on the circuit layer. The encapsulation layer is disposed on the substrate and covers the plurality of light-emitting elements. The encapsulation layer has a first surface and a second surface, wherein the first surface of the encapsulation layer is away from the substrate and corresponds to the plurality of light-emitting elements, and the second surface of the encapsulation layer is away from the substrate and corresponds to at least part of a space between the two adjacent light-emitting elements. A difference between the first surface and the second surface is greater than or equal to 0.4 µm and less than or equal to 25 µm.

## Description

### BACKGROUND

### Technical Field

The disclosure relates to a display device and a manufacturing method thereof, and in particular to a display device and a packaging method thereof.

### Description of Related Art

In the manufacturing process of display device, it is necessary to move the intermediate product (the unfinished display device) during the process. Therefore, how to reduce the possibility of damage to the intermediate product during the movement is one of the current goals.

### SUMMARY

The disclosure provides a display device a display device and a manufacturing method of a display device, which enables the display device to have the relatively good yield.

According to some embodiments of the disclosure, the display device comprises a substrate, a circuit layer, a plurality of light-emitting elements, and an encapsulation layer. The circuit layer is disposed on the substrate. The plurality of light-emitting elements are disposed on the circuit layer. The encapsulation layer is disposed on the substrate and covers the plurality of light-emitting elements. The encapsulation layer has a first surface and a second surface, wherein the first surface of the encapsulation layer is away from the substrate and corresponds to the plurality of light-emitting elements, and the second surface of the encapsulation layer is away from the substrate and corresponds to at least part of a space between the two adjacent light-emitting elements. A first distance between the first surface of the encapsulation layer and the substrate in a normal direction is different from a second distance between the second surface of the encapsulation layer and the substrate in the normal direction, and a difference between the first surface and the second surface is greater than or equal to 0.4 µm and less than or equal to 25 µm.

According to some embodiments of the disclosure, the manufacturing method of the display device comprises the following steps. Manufacturing a display panel, which includes the following steps. Providing a substrate. Forming a circuit layer on the substrate. Disposing a plurality of light-emitting elements on the circuit layer. Forming an encapsulation layer covering the plurality of light-emitting elements on the substrate. The encapsulation layer has a first surface and a second surface, the first surface of the encapsulation layer is away from the substrate and corresponds to the plurality of light-emitting elements, and the second surface of the encapsulation layer is away from the substrate and corresponds to at least part of a space between the two adjacent light-emitting elements. A first distance between the first surface of the encapsulation layer and the substrate in a normal direction is different from a second distance between the second surface of the encapsulation layer and the substrate in the normal direction. Attaching a protective film to the encapsulation layer of the display panel.

### BRIEF DESCRIPTION OF THE DRAWINGS

FIG. 1 is a cross-sectional view of a process flow for a manufacturing method of a display device according to one embodiment of the disclosure.
FIG. 2A is a top view of a display device according to a first embodiment of the disclosure, FIG. 2B is a partial cross-sectional view taken along a line A-A' in FIG. 2A, and FIG. 2C is a partial cross-sectional view taken along a line B-B' in FIG. 2A.
FIG. 3 is a partial cross-sectional view of a display device according to a second embodiment of the disclosure.
FIG. 4 is a top view of a display device according to a third embodiment of the disclosure.
FIG. 5A is a partial cross-sectional view of a display device according to a fourth embodiment of the disclosure, and FIG. 5B is a partial cross-sectional view of a display device according to a fifth embodiment of the disclosure.
FIG. 6A is a partial cross-sectional view of a display device according to a sixth embodiment of the disclosure, FIG. 6B is a partial cross-sectional view of a display device according to a seventh embodiment of the disclosure, and FIG. 6C is a partial cross-sectional view of a display device according to an eighth embodiment of the disclosure.
FIG. 7A is a top view of a display device according to a ninth embodiment of the disclosure, and FIG. 7B is a partial cross-sectional view taken along a line C-C' in FIG. 7A.
FIG. 8A is a top view of a display device according to a tenth embodiment of the disclosure, and FIG. 8B is a partial cross-sectional view taken along a line D-D' in FIG. 8A.
FIG. 9A is a top view of a display device according to an eleventh embodiment of the disclosure, and FIG. 9B is a partial cross-sectional view taken along a line E-E' in FIG. 9A.
FIG. 10A is a top view of a display device according to a twelfth embodiment of the disclosure, FIG. 10B is a partial cross-sectional view taken along a line F-F' in FIG. 10A, and FIG. 10C is a top view of a display device according to a thirteenth embodiment of the disclosure.

### DESCRIPTION OF THE EMBODIMENTS

The disclosure can be understood by referring to the following detailed description and combined with the accompanying drawings. It should be noted that, in order to make the readers easy to understand and the drawings to be concise, the drawings in the disclosure only depict part of the electronic devices, and certain elements in the drawings are not drawn to actual scale. In addition, the number of components and the size of components in the drawings are only for illustration and are not intended to limit the scope of the disclosure.

Throughout the specification and the appended claims of the disclosure, certain terms may be used to refer to specific elements. It should be understood by persons skilled in the art that electronic device manufacturers may refer to the same element by different names. The disclosure does not intend to distinguish between elements with the same function but different names. In the following specification and claims, terms such as "including", "containing", and "having" are open-ended terms, so the terms should be interpreted as "containing but not limited to...". Therefore, when the terms "including", "containing", and/or "having" are used in the description of the disclosure, the terms designate the presence of a corresponding feature, region, step, operation, and/or component, but do not exclude the presence of one or more corresponding features, regions, steps, operations, and/or components.

Directional terms (such as: "up", "down", "front", "back", "left", "right", etc.) mentioned in disclosure are only for reference to the directions of the accompanying drawings. Accordingly, the directional terms used are illustrative and not limiting of the disclosure. In the drawings, each illustrates the general features of methods, structures, and/or materials used in particular embodiments. However, these drawings should not be interpreted as defining or limiting the scope or nature encompassed by these embodiments. For example, the relative sizes, thicknesses, and locations of various layers, regions, and/or structures may be reduced or exaggerated for clarity.

When a corresponding component (for example, a film layer or a region) is referred to as being "on another component", the component may be directly on the other component or there may be another component between the two. On the other hand, when a component is referred to as being "directly on another component", unless additionally described in the specification, there is no component between the two. In addition, when a component is referred to as being "on another component", the two have an upper-lower relationship in the top view direction, and the component may be above or below the other component, and the upper-lower relationship depends on the orientation of the device.

The terms "approximately", "equal to", "equal" or "the same", "substantially" or "substantially" are generally interpreted to mean within 20% of a given value or range, or to mean within 10%, 5%, 3%, 2%, 1% or 0.5% of a given value or range.

Ordinal numbers such as "first" and "second" used in the specification and the claims are used to modify elements, and the terms do not imply and represent that the element(s) have any previous ordinal numbers, nor do they represent the order of a certain element and another element or the order of a manufacturing method. The use of the ordinal numbers is only to clearly distinguish between an element with a certain name and another element with the same name. The claims and the specification may not use the same terms, whereby a first component in the specification may be a second component in the claims.

It should be noted that in the following embodiments, features in several different embodiments can be replaced, reorganized, and mixed without departing from the spirit of the disclosure to complete other embodiments. Features in various embodiments may be mixed and matched as long as they do not violate the spirit of the disclosure or conflict with each other.

Electrical connection described in the disclosure may refer to direct connection or indirect connection. In the case of direct connection, terminals of elements on two circuits are directly connected or connected to each other by a conductor segment. In the case of indirect connection, there is a switch, a diode, a capacitor, an inductor, other suitable elements, or a combination of the above elements between the terminals of the elements on the two circuits.

The measurement manner of thickness, length, width, and area may be by adopting an optical microscope, and the thickness may be obtained by measuring a cross-sectional image in an electron microscope. In addition, there may be a certain error in any two values or directions for comparison. If a first value is equal to a second value, it implies that there may be an error of about 10% between the first value and the second value. If a first direction is perpendicular to a second direction, an angle between the first direction and the second direction may be between 80 degrees and 100 degrees; and if the first direction is parallel to the second direction, the angle between the first direction and the second direction may be between 0 degrees and 10 degrees.

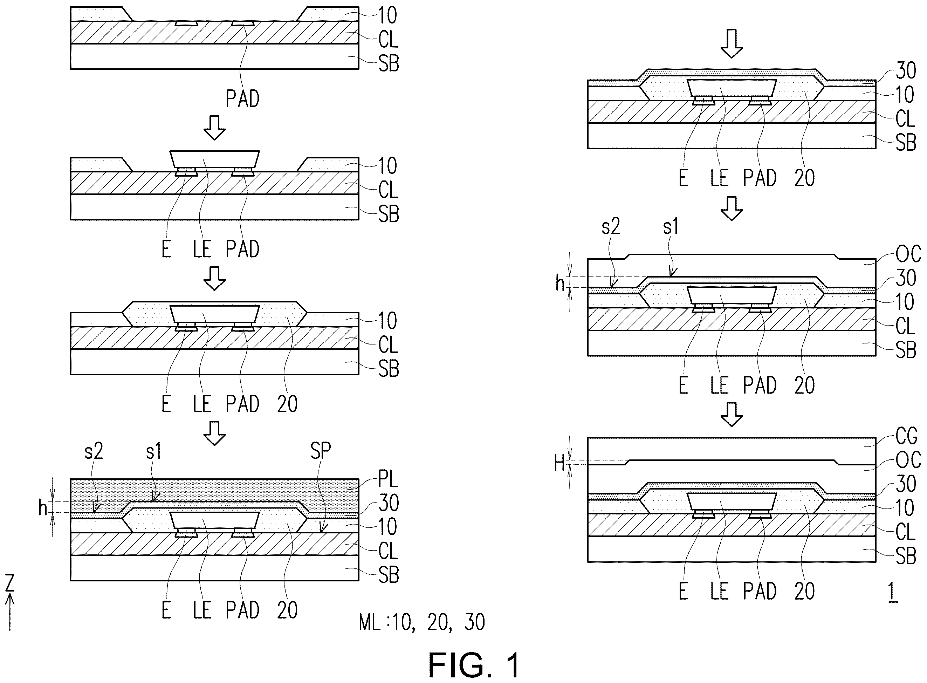

Referring to FIG. 1, a manufacturing method of a display device 1 is provided, comprising the following steps. The display device 1 may include a transparent display device, a double-sided display device, a virtual reality display device, an augmented reality display device, a 3D display device, a spliced display device, a flexible display device, a foldable display device, or a combination thereof.

Step (1): manufacturing a display panel DP.

In some embodiments, the manufacturing method includes the following steps.

Step (1-1): providing a substrate SB.

The substrate SB includes a flexible substrate or a non-flexible substrate. A material of the substrate SB includes glass, plastic, any light-transmitting material, or a combination thereof.

Step (1-2): Forming a circuit layer CL on the substrate SB.

The circuit layer CL is disposed on the substrate SB. In some embodiments, the circuit layer CL may include a stack of multiple conductive layers (not shown) and multiple insulating layers (not shown), wherein the two adjacent conductive layers may be electrically connected to each other through an opening (not shown) in the insulating layer therebetween to form the corresponding conductive transmission path. In some embodiments, the circuit layer CL may include a plurality of transistors, capacitors, and/or a plurality of electrodes. In the embodiment, the circuit layer CL includes a plurality of pads PAD.

Step (1-3): disposing a plurality of light-emitting elements LE on the circuit layer CL.

The plurality of light-emitting elements LE may be electrically connected to the corresponding transistors in the circuit layer CL. Specifically, electrodes E of the plurality of light-emitting elements LE are disposed on the plurality of pads PAD of the circuit layer CL, and are electrically connected to the corresponding transistors through the plurality of pads PAD. In some embodiments, the plurality of light-emitting elements LE may include organic light-emitting diodes (OLEDs), mini light-emitting diodes (mini LEDs), micro light-emitting diodes (micro LEDs), quantum dot light-emitting diodes (quantum dot LEDs), or a combination thereof. It is worth noting that although FIG. 1 shows only one light-emitting element LE, the plurality of light-emitting elements LE could be provided.

Step (1-4): Forming an encapsulation layer ML on the substrate SB.

The encapsulation layer ML can be manufactured by performing a plurality of development processes, a plurality of development processes using halftone mask, a plurality of inkjet printing processes, other suitable processes, or a combination thereof. The encapsulation layer ML is disposed on the substrate and covers the plurality of light-emitting elements LE. Furthermore, the encapsulation layer ML is one or more film layers disposed above the circuit layer CL and covering the plurality of light-emitting elements LE. In the embodiment, the encapsulation layer ML has a first surface s1 and a second surface s2. The first surface s1 of the encapsulation layer ML is away from the substrate SB and corresponds to the plurality of light-emitting elements LE, and the second surface s2 of the encapsulation layer ML is away from the substrate SB and corresponds to at least part of a space SP between the two adjacent light-emitting elements LE.

The encapsulation layer ML includes a sub-encapsulation layer 10 and a sub-encapsulation layer 20, wherein the sub-encapsulation layer 10 can be formed before the sub-encapsulation layer 20. In some embodiments, the sub-encapsulation layer 10 may be formed after the light emitting element LE and the sub-encapsulation layer 20 are formed. In some embodiments, the encapsulation layer ML may selectively include a sub-encapsulation layer 30.

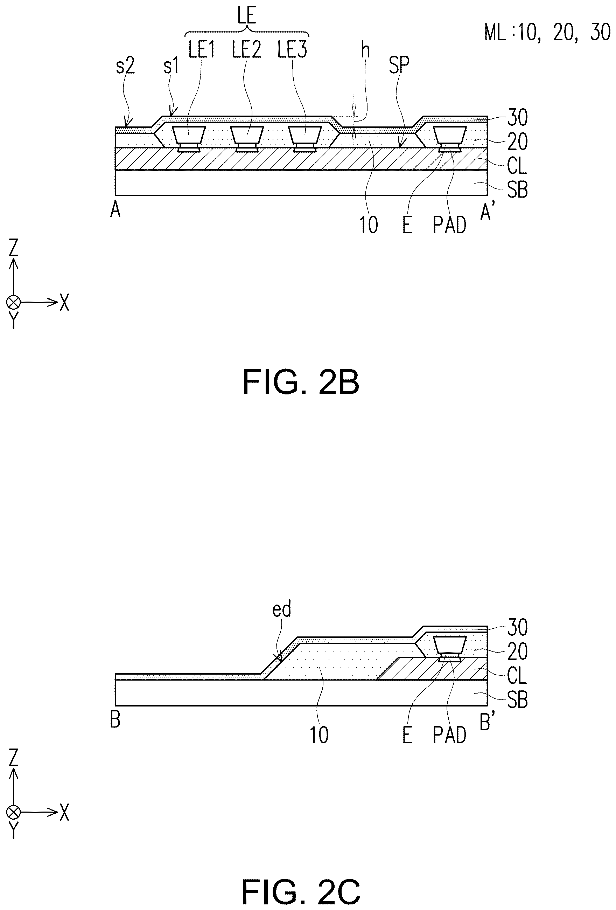

The sub-encapsulation layer 10 overlaps at least part of the space SP between the two adjacent light-emitting elements LE in a normal direction Z and has an edge ed (in FIG. 2C). In some embodiments, the sub-encapsulation layer 10 can be used to define the position of the plurality of light-emitting elements LE, but the disclosure is not limited thereto.

The sub-encapsulation layer 20 overlaps the plurality of light-emitting elements LE in the normal direction Z and is adjacent to the sub-encapsulation layer 10. In some embodiments, the sub-encapsulation layer 20 covers the plurality of light-emitting elements LE and fills a space formed between the light-emitting elements LE and the circuit layer CL.

The sub-encapsulation layer 30 overlaps the plurality of light-emitting elements LE and the space SP in the normal direction Z. In the embodiment, the sub-encapsulation layer 30 is disposed on the sub-encapsulation layer 10 and the sub-encapsulation layer 20. In the embodiment, materials of the sub-encapsulation layer 10 and the sub-encapsulation layer 20 can include suitable organic materials, and a material of the sub-encapsulation layer 30 can include suitable inorganic materials. The material of sub-encapsulation layer 30 may include silicon oxide (SiOₓ), silicon nitride (SiNₓ), silicon oxynitride (SiOₓN_{y}), or a combination thereof, to enhance the ability to block the moisture and/or oxygen. In some embodiments, the sub-encapsulation layer (for example, the sub-encapsulation layer 20 and the sub-encapsulation layer 30) overlapping the plurality of light-emitting elements LE in the normal direction Z has a light transmittance greater than or equal to 80%. In the disclosure, the materials and/or functions of the sub-encapsulation layers 10, 20, and 30 can be referred to above and are omitted below.

In the embodiment, a first distance between the first surface s1 of the encapsulation layer ML and the substrate SB in the normal direction Z is different from a second distance between the second surface s2 of the encapsulation layer ML and the substrate SB in the normal direction Z, and a first difference h is present between the first surface s1 of the encapsulation layer ML and the second surface s2 of the encapsulation layer ML. The first surface s1 of the encapsulation layer ML is a surface of a sub-encapsulation layer that overlaps the plurality of light-emitting elements LE, and the second surface s2 of the encapsulation layer ML is a surface of a sub-encapsulation layer that overlaps the space SP. For example, the first surface s1 and the second surface s2 are both surfaces of the sub-encapsulation layer 30, but the disclosure is not limited thereto. In some embodiments, the first surface s1 is a surface of the sub-encapsulation layer 10, and the second surface s2 is a surface of the sub-encapsulation layer 20.

Referring to FIG. 2C, in the embodiment, the sub-encapsulation layer 10 covers sidewalls of the circuit layer CL, and the sub-encapsulation layer 30 covers sidewalls of the sub-encapsulation layer 10 to reduce the effects of the moisture and/or oxygen on the components in the circuit layer CL. In the embodiment, the sub-encapsulation layer 30 covers the entire substrate SB. In some embodiments, the sub-encapsulation layer 30 only covers a portion of the substrate SB, leaving another portion of the substrate SB exposed.

Step (1-5): attaching a protective film PL to the encapsulation layer ML.

The protective film PL covers the encapsulation layer ML to protect the display panel DP and/or the encapsulation layer ML. A material of the protective film PL may include a suitable inorganic material, an organic material, or a combination thereof. Attaching the protective film PL to the encapsulation layer ML can reduce the possibility of damage to the display device 1 during the process and/or during the movement of the display panel DP.

Step (1-6): removing the protective film PL.

When performing the subsequent processes to form the display device 1, the protective film PL is separated from the encapsulation layer ML by a suitable mechanical peeling process.

Step (1-7): providing a substrate CG.

The substrate CG may be a cover plate. The substrate CG may include dustproof, scratch-resistant, and water-resistant features to reduce the impact of the external environment on the components within the display device 1, and may be light-transmissive. A material of the substrate CG can refer to the material of the substrate SB, and will be omitted herein.

Step (1-8): forming an adhesive layer OC on the encapsulation layer ML or the substrate CG.

In the embodiment, the adhesive layer OC is formed on the encapsulation layer ML. A material of the adhesive layer OC may include an optically clear resin (OCR) or an optically clear adhesive (OCA). For example, the material of the adhesive layer OC may include acrylic resin, silicone resin, epoxy resin, or other suitable materials or combinations thereof.

Step (1-9): assembling the display panel DP and the substrate CG via the adhesive layer OC.

The adhesive layer OC can be disposed on the encapsulation layer ML or be disposed on the substrate CG. Thus, the adhesive layer OC can bond the encapsulation layer ML on the substrate SB and the substrate CG to each other to complete the alignment.

In the disclosure, after aligning the display panel DP and the substrate CG, a top surface of the adhesive layer OC also has a second difference H due to the topography caused by the encapsulation layer ML, and the second difference H can be smaller than the first difference h. In some embodiments, a thickness of the adhesive layer OC is greater than a thickness of the encapsulation layer ML. In some embodiments, the top surface of the adhesive layer OC can be a flat top surface without the second difference H.

The detailed structure of the display device 1 will be described below with reference to various embodiments, wherein the adhesive layer OC and the substrate CG provided on the encapsulation layer ML in the display device 1 are omitted for description.

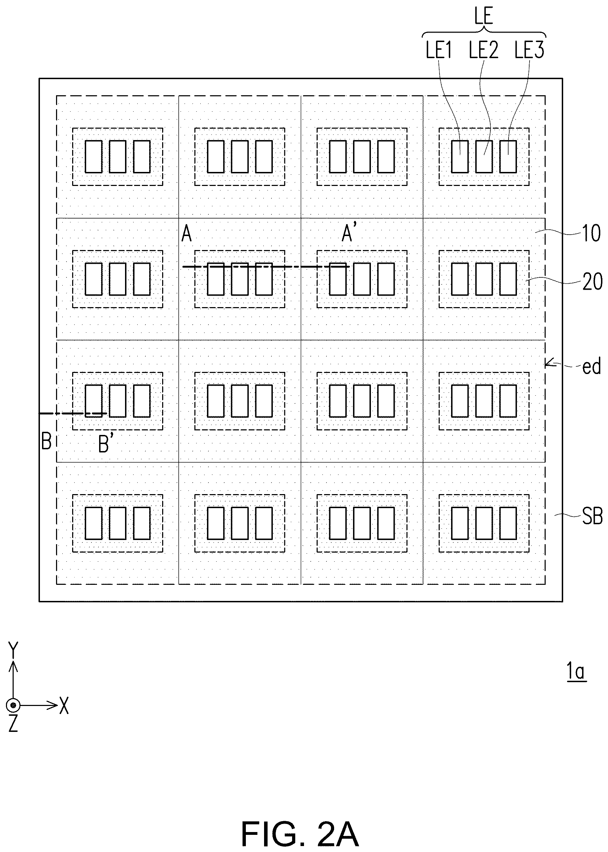

Referring to FIGs. 2A-2C, a display device 1a includes the substrate SB, the circuit layer CL, the plurality of light-emitting elements LE, and the encapsulation layer ML.

In the embodiment, the plurality of light-emitting elements LE includes a light-emitting element LE1, a light-emitting element LE2, and a light-emitting element LE3 arranged in a direction X. In some embodiments, the plurality of light-emitting elements LE may be arranged in an array on a plane formed by the direction X and a direction Y. In the embodiment, the light-emitting element LE1~LE3 may be a red, green, and blue light-emitting element, respectively, but not limited thereto.

In the embodiment, a thickness of the sub-encapsulation layer 10 in the normal direction Z is different from (for example, less than) a thickness of the sub-encapsulation layer 20 in the normal direction Z, so that the encapsulation layer ML can form the first surface s1 and the second surface s2 at different distances from the substrate SB. The first difference h between the first surface s1 and the second surface s2 can be greater than or equal to 0.4 µm and less than or equal to 25 µm, or greater than or equal to 0.4 µm and less than or equal to 15 µm. When the first difference h is within the above range, a surface area of the encapsulation layer ML can be effectively increased, thereby improving the adhesion of the protective film (not shown) subsequently applied to the encapsulation layer ML, thereby reducing the problem of the protective film falling off, so as to improve the protection effect and yield of the display panel DP. Furthermore, it can also improve the levelness of the adhesive layer OC with respect to the surface of the encapsulation layer ML, thereby reducing the risk of bubbles forming therein. In the disclosure, each of the following embodiments can achieve the range of the above first difference on the surface of the encapsulation layer and achieve the above effects.

In other embodiments, one of the sub-encapsulation layers (for example, the sub-encapsulation layer 20) of the encapsulation layer ML may include a plurality of island-shaped patterns, and each island-shaped pattern may correspond to the light-emitting element LE and/or may not correspond to the light-emitting element LE, thereby increasing its surface area. In other embodiments, one of the sub-encapsulation layers (for example, the sub-encapsulation layer 20) of the encapsulation layer ML includes a mesh-shaped pattern, the mesh-shaped pattern including a plurality of solid portions, a plurality of connecting portions, and a plurality of hollow portions, wherein the connecting portions are connected to two solid portions, and the hollow portions are defined by being surrounded by the solid portions and the connecting portions. Each solid portion may correspond to the light-emitting element LE. Through the design of the above sub-encapsulation layer, the surface of the encapsulation layer ML may also present the first difference h, thereby achieving the above effects.

Other embodiments of the present disclosure will be described in detail below. To simplify the description, the same reference numerals will be used to identify the same elements. To highlight the differences between the various embodiments, the differences between the various embodiments will be described in detail below, and repeated technical features will not be repeated. In addition, these repeated technical features can be applied to the following embodiments.

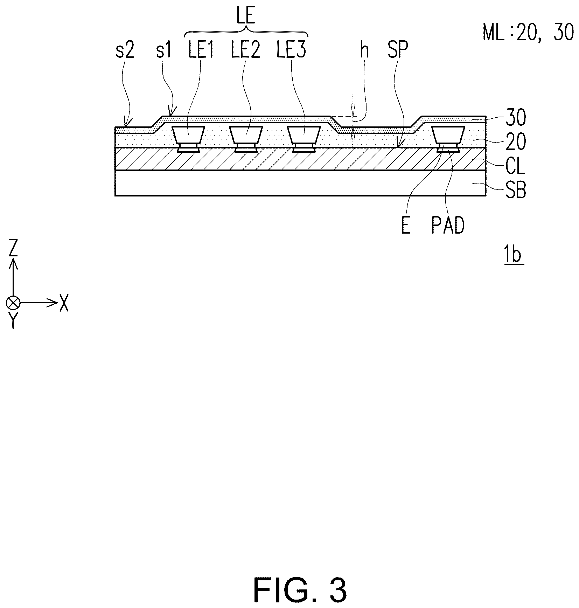

Referring to FIG. 3, the main difference between a display device 1b and the display device 1a is that the display device 1b does not include the sub-encapsulation layer 10.

Specifically, the sub-encapsulation layer 20 overlaps the plurality of light-emitting elements LE and at least part of the space SP between the two adjacent light-emitting elements LE in the normal direction Z. In the embodiment, the sub-encapsulation layer 20 is formed by using a halftone mask or a grayscale mask to provide the encapsulation layer ML with the first difference h. It is noting that the range and the effect of the first difference h are described above.

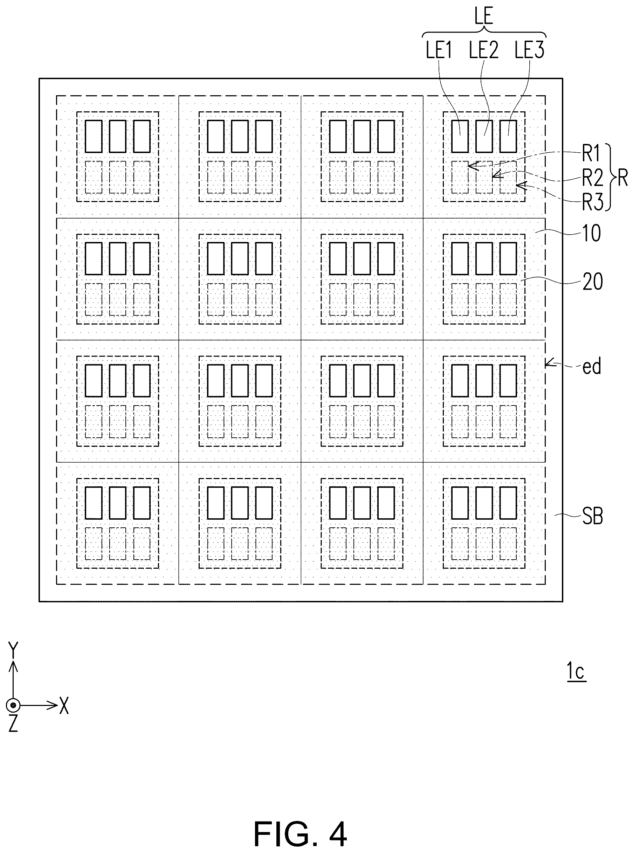

Referring to FIG. 4, the main difference between a display device 1c and the display device 1a is that the display device 1c further includes a reductant region R.

A plurality of reductant pads (not shown) may be disposed in the reductant region R, wherein a material of the plurality of reductant pads may be the same as that of the pad PAD. For example, the material of the plurality of reductant pads includes a metal, a metal oxide, or another suitable conductive material. The reductant region R includes a reductant region R1, a reductant region R2, and a reductant region R3, each corresponding to a light-emitting element LE1, a light-emitting element LE2, and a light-emitting element LE3. In some embodiments, when a defect is detected in the light-emitting element LE1, the light-emitting element LE2, and/or the light-emitting element LE3, a new light-emitting element LE1, a new light-emitting element LE2, and/or a new light-emitting element LE3 may be transferred to the corresponding reductant region R1, the reductant region R2, and the reductant region R3. Therefore, the provision of the reductant region R can improve the yield of manufacturing the display device 1c.

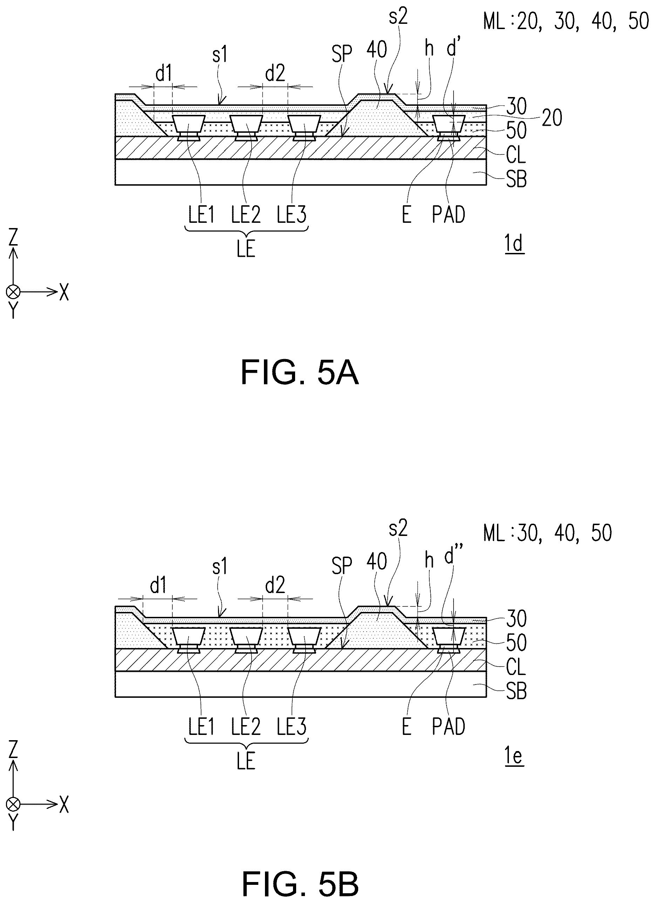

Referring to FIG. 5A, the main difference between a display device 1d and the display device 1a is that the sub-encapsulation layer 10 provided in the display device 1a can be replaced by a sub-encapsulation layer 40, and the encapsulation layer ML further includes a sub-encapsulation layer 50.

A material of the sub-encapsulation layer 40 may include a suitable organic material and have a light transmittance less than or equal to 20%. The provision of the sub-encapsulation layer 40 can shield light from being reflected by the metal layer, thereby improving the contrast of the display device 1d. In the disclosure, the material and/or the function of the sub-encapsulation layer 40 can refer to the above description and will be omitted herein. In some embodiments, in an active region of the display device 1d, a ratio between an area of the region without the sub-encapsulation layer 40 and an area of the region with the sub-encapsulation layer 40 is less than or equal to 0.8.

The sub-encapsulation layer 50 is adjacent to the sub-encapsulation layer 40 and is disposed between the sub-encapsulation layer 20 and the circuit layer CL in the normal direction Z. In the embodiment, the sub-encapsulation layer 50 may be disposed between the adjacent light-emitting elements LE, and may be disposed between the sub-encapsulation layer 40 and the light-emitting element LE. A material of the sub-encapsulation layer 50 may include a suitable organic material having white or other suitable colors to scatter the light emitted by the corresponding light-emitting element LE, thereby improving the light utilization efficiency and/or the light intensity, but the disclosure is not limited thereto. In the disclosure, the material and/or the function of the sub-encapsulation layer 50 can refer to the above description and will be omitted herein. In some embodiments, a distance d' between a top surface of the sub-encapsulation layer 50 and a top surface of the light-emitting element LE may be less than or equal to 6 µm. An edge of the top surface of the sub-encapsulation layer 50 that contacts the sub-encapsulation layer 40 is spaced an interval d1 from the top surface of the light-emitting element LE in the direction X, and an interval d2 between the adjacent light-emitting elements LE in the direction X. The interval d1 and the interval d2 may be greater than or equal to 2 mm, so as to ensure that the light utilization efficiency of the light emitting element LE can be effectively improved regardless of whether the process deviation occurs.

In the embodiment, a thickness of the sub-encapsulation layer 40 in the normal direction Z is different from (for example, greater than) a total thickness of the sub-encapsulation layer 20 and the sub-encapsulation layer 50 in the normal direction Z, such that the first difference h exists between the first surface s1 of the encapsulation layer ML and the second surface s2 of the encapsulation layer ML. The range and the function of the first difference h are described above.

In the embodiment, forming the sub-encapsulation layers in the encapsulation layer ML may be forming the sub-encapsulation layer 40, the sub-encapsulation layer 50, the sub-encapsulation layer 20, and the sub-encapsulation layer 30 in this sequence. It is worth noting that the sub-encapsulation layer 10 in the display devices 1a, 1b, and 1c shown in the above embodiments can all be replaced with the sub-encapsulation layer 40 having a transmittance less than or equal to 20%.

Referring to FIG. 5B, the main difference between a display device 1e and the display device 1d is that the region of the display device 1d where the sub-encapsulation layer 20 is provided can be replaced by the sub-encapsulation layer 50, thereby increasing the thickness of the sub-encapsulation layer 50 to cover the plurality of light-emitting elements LE.

In the embodiment, a distance d" between the top surface of the sub-encapsulation layer 50 and the top surface of the light-emitting element LE can be less than or equal to 3 µm. The ranges of the interval d1 and the interval d2 are described in FIG. 5A and will be omitted herein.

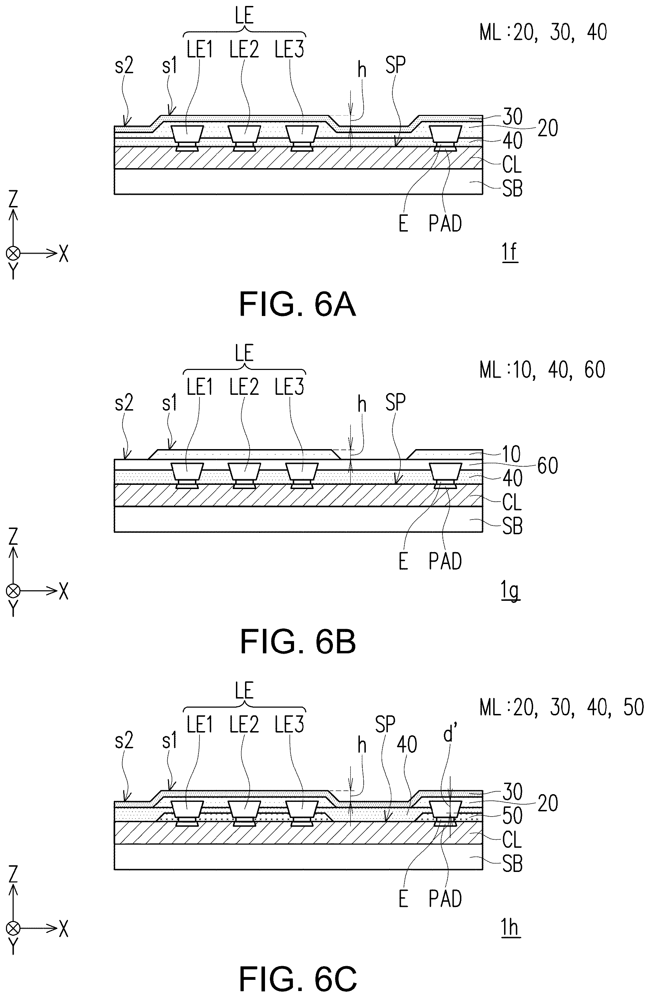

Referring to FIG. 6A, the main difference between a display device 1f and the display device 1b is that the display device 1f further includes the sub-encapsulation layer 40 disposed between the sub-encapsulation layer 20 and the circuit layer CL, wherein the sub-encapsulation layer 40 has a light transmittance of less than or equal to 20%.

In the embodiment, the sub-encapsulation layer 30 only covers and contacts the sub-encapsulation layer 20, but the disclosure is not limited thereto. In some embodiments, the sub-encapsulation layer 20 may not correspond to at least part of the space SP between the two adjacent light-emitting elements LE, and thus the sub-encapsulation layer 30 may cover and contact both the sub-encapsulation layer 20 and the sub-encapsulation layer 40.

Referring to FIG. 6B, the main difference between the display device 1g and the display device 1f is that the display device 1g includes a sub-encapsulation layer 60 and the sub-encapsulation layer 10 disposed on the sub-encapsulation layer 40.

The sub-encapsulation layer 60 is disposed on the sub-encapsulation layer 40 and may cover the plurality of light-emitting elements LE and at least part of the space SP between the two adjacent light-emitting elements LE. A material of the sub-encapsulation layer 60 may include a suitable inorganic material, such as spin-on glass (SOG), spin-on dielectric (SOD), or a combination thereof, and have a light transmittance greater than or equal to 80%, but the disclosure is not limited thereto.

The sub-encapsulation layer 10 is disposed on the sub-encapsulation layer 60 and corresponds to the plurality of light-emitting elements LE, but does not correspond to at least part of the space SP between the two adjacent light-emitting elements LE. With this configuration, the first difference h can be provided between the first surface s1 of the encapsulation layer ML and the second surface s2 of the encapsulation layer ML. The range and the effect of the first difference h can be referred to the above description.

Referring to FIG. 6C, the main difference between a display device 1h and the display device 1f is that the display device 1h further includes the sub-encapsulation layer 50, wherein the sub-encapsulation layer 50 is disposed between the circuit layer CL and the sub-encapsulation layer 40 in the normal direction Z and corresponds to the plurality of light-emitting elements LE. Furthermore, in the embodiment, the sub-encapsulation layer 20 also corresponds to the plurality of light-emitting elements LE, but the disclosure is not limited thereto. This configuration allows the first difference h to be defined between the first surface s1 of the encapsulation layer ML and the second surface s2 of the encapsulation layer ML. The range and the effect of the first difference h can be referred to the above description.

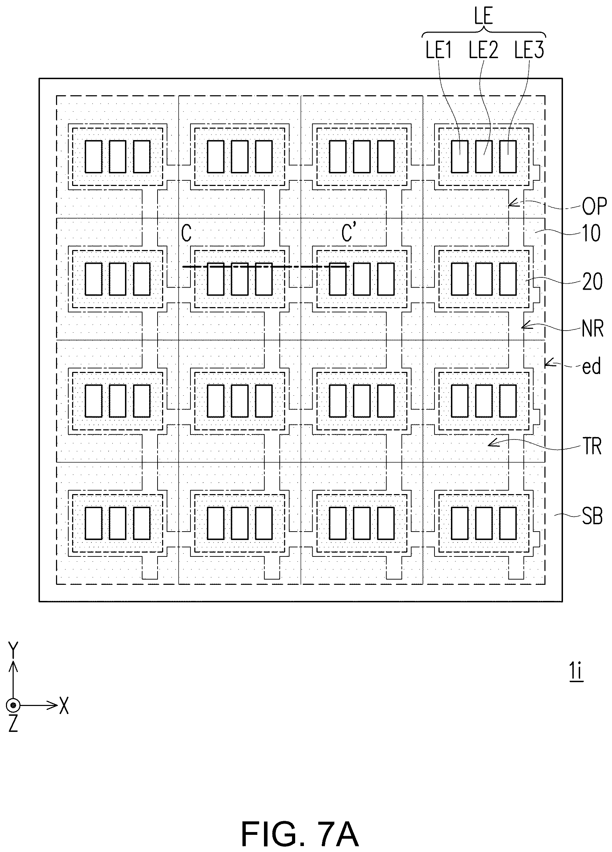

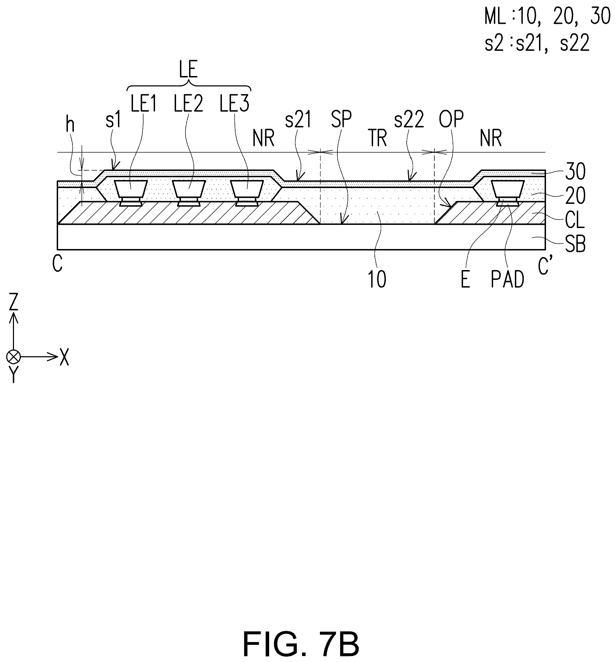

Referring to FIGs. 7A and 7B, the main difference between a display device 1i and the display device 1a is that the display device 1i comprises at least one non-light-transmitting region NR and at least one light-transmitting region TR. Specifically, the display device 1i may be a transparent display device, which can be used in a transparent display, a display with under-display cameras (UDCs), and other display requiring the transparent region. In some embodiments, the method of forming the display device 1i further includes patterning the circuit layer CL to form at least one opening OP.

The non-light-transmitting region NR may be a region defined by a non-light-transmitting material and/or a non-light-transmitting element. The non-light-transmitting element may include the plurality of light-emitting elements LE, signal lines, or other electronic elements (such as capacitors, resistors, inductors, diodes, transistors, and/or sensors). The non-light-transmitting material may include metal, light-shielding material, and/or other materials that affect light penetration.

The light-transmitting region TR is a region outside of the at least one non-light-transmitting region NR. The at least one light-transmitting region TR may be separated from each other by the at least one non-light-transmitting region NR, but the disclosure is not limited thereto. In the embodiment, the at least one non-light-transmitting region NR surrounds the at least one light-transmitting region TR. From another perspective, the circuit layer CL has the at least one opening OP corresponding to the at least one light-transmitting region TR, and the plurality of light-emitting elements LE correspond to the at least one non-light-transmitting region NR, wherein the sub-encapsulation layer 10 corresponds to the at least one non-light-transmitting region NR and the at least one light-transmitting region TR.

The first difference h is defined between the first surface s1 of the encapsulation layer ML and the second surface s2 of the encapsulation layer ML. The range and the effect of the first difference h can be referred to the above description. In the embodiment, the second surface s2 of the encapsulation layer ML may include a first portion s21 corresponding to the at least one non-light-transmitting region NR and a second portion s22 corresponding to the at least one light-transmitting region TR.

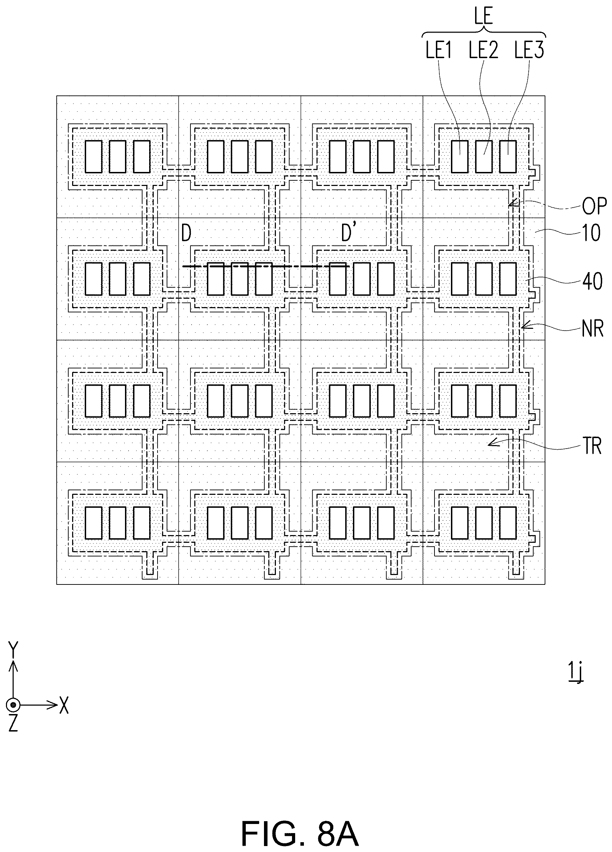

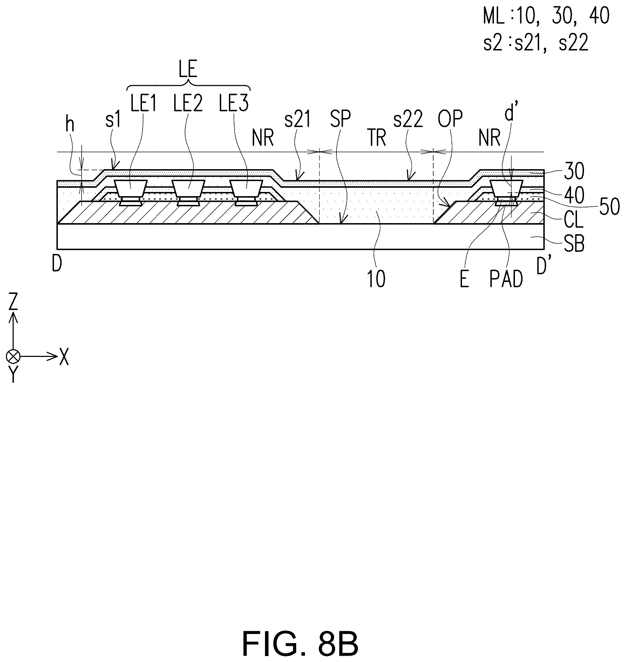

Referring to FIGs. 8A and 8B, the main difference between a display device 1j and the display device 1i is that the display device 1j includes the sub-encapsulation layer 40 and the sub-encapsulation layer 50 corresponding to the at least one non-light-transmitting region NR.

The sub-encapsulation layer 50 is disposed between the sub-encapsulation layer 40 and the circuit layer CL, and both the sub-encapsulation layer 40 and the sub-encapsulation layer 50 correspond to the plurality of light-emitting elements LE. In some embodiments, the sub-encapsulation layer 50 is optionally disposed. The sub-encapsulation layer 10 is disposed on the sub-encapsulation layer 40 and covers the plurality of light-emitting elements LE. Specifically, the sub-encapsulation layer 10 corresponds to the plurality of light-emitting elements LE and the at least part of the space SP between the two adjacent light-emitting elements LE.

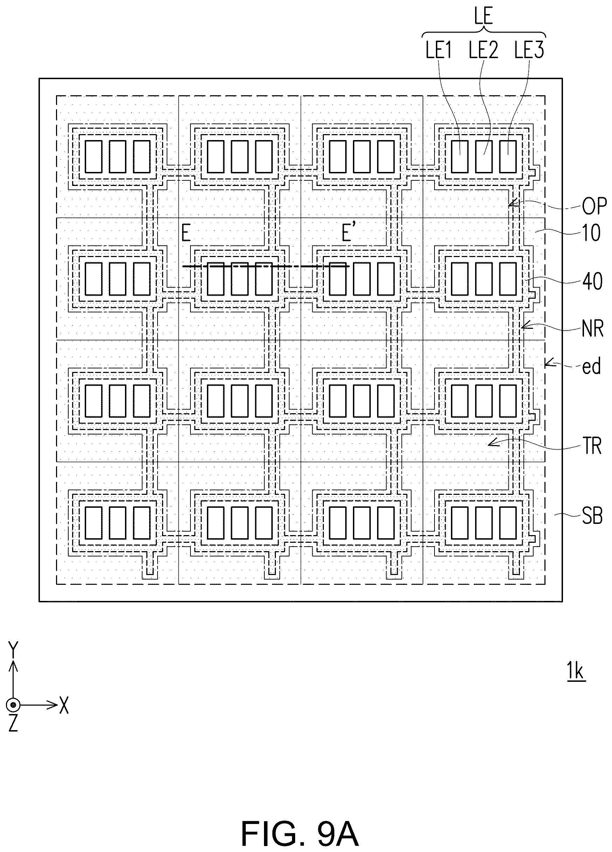

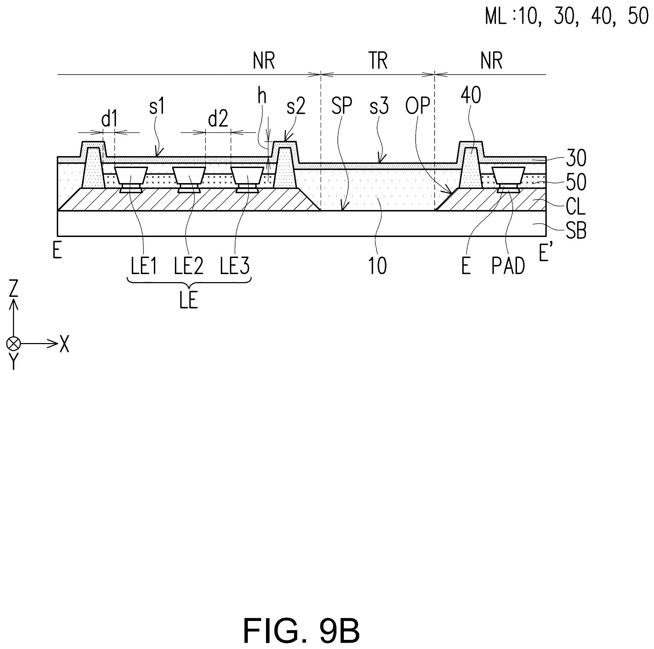

Referring to FIGs. 9A and 9B, the main difference between a display device 1k and the display device 1j is that the sub-encapsulation layer 40 of the display device 1k is disposed around the plurality of light-emitting elements LE and does not overlap the plurality of light-emitting elements LE in the normal direction.

The sub-encapsulation layer 40 is disposed on the circuit layer CL and can be used to define the positions of the plurality of light-emitting elements LE. In the embodiment, the sub-encapsulation layer 50 is surrounded by the sub-encapsulation layer 40.

The sub-encapsulation layer 10 can be selectively corresponded to the plurality of light-emitting elements LE. For example, in FIG. 9B, the sub-encapsulation layer 10 can be corresponded to the at least one non-light-transmitting region NR and the at least one light-transmitting region TR, and can correspond to the plurality of light-emitting elements LE and at least part of the space SP between the two adjacent light-emitting elements LE. In some embodiments, the sub-encapsulation layer 10 may not be corresponded to the at least one non-light-transmitting region NR, and the sub-encapsulation layer 50 may be provided to cover a plurality of light-emitting elements LE.

In the embodiment, the first surface s1 of the encapsulation layer ML corresponds to the plurality of light-emitting elements LE, and the second surface s2 of the encapsulation layer ML corresponds to the sub-encapsulation layer 40. The first difference h is defined between the first surface s1 of the encapsulation layer ML and the second surface s2 of the encapsulation layer ML. The range and the effect of the first difference h can be referred to the above description.

In the embodiment, the encapsulation layer ML further has a third surface s3, wherein the third surface s3 corresponds to the at least one light-transparent region TR. A third distance between the third surface s3 and the substrate SB in the normal direction Z is different from the first distance between the first surface s1 and the substrate SB in the normal direction Z, and is different from the second distance between the second surface s2 and the substrate SB in the normal direction Z, but the disclosure is not limited thereto. In some embodiments, the third distance is the same as the first distance.

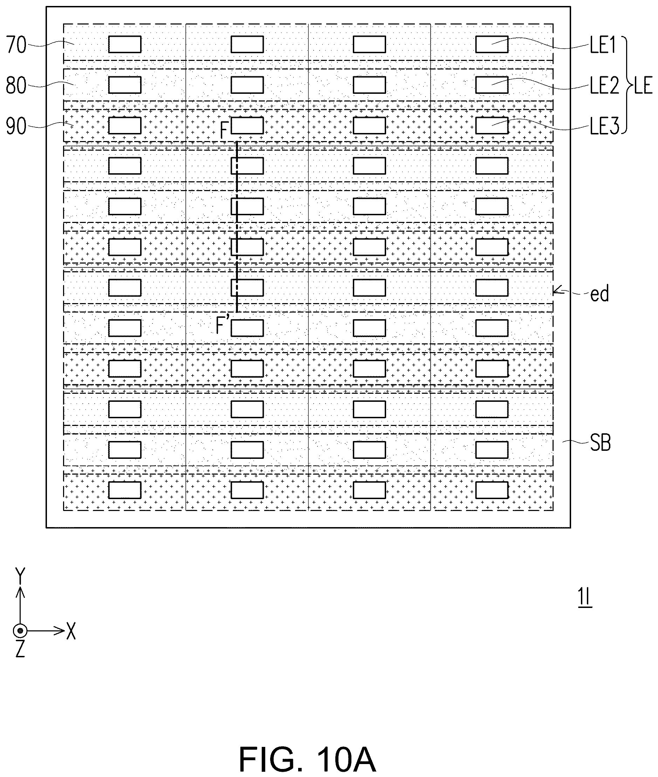

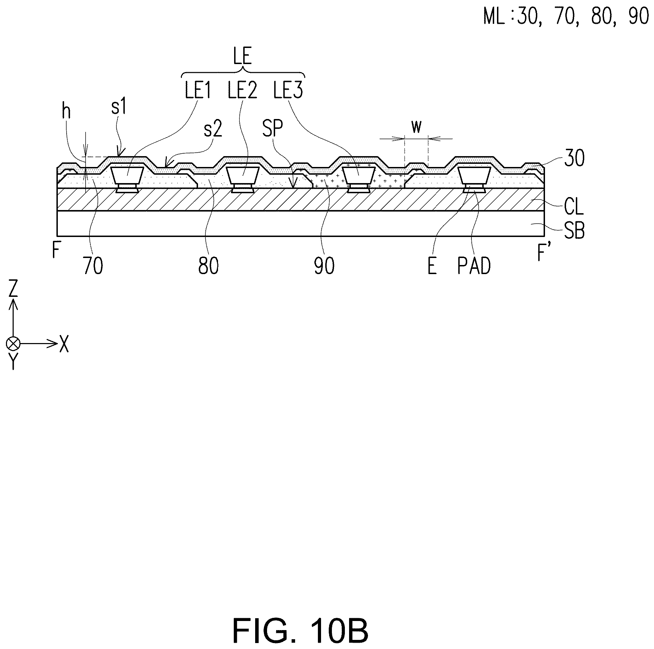

Referring to FIGs. 10A and 10B, the main difference between a display device 1l and the display device 1a is that the encapsulation layer ML in the display device 11 includes a sub-encapsulation layer 70, a sub-encapsulation layer 80, and a sub-encapsulation layer 90.

The sub-encapsulation layer 70 is disposed on the light-emitting element LE1 and has a first color. The sub-encapsulation layer 80 is disposed on the second light-emitting element LE2 and has a second color different from the first color. The sub-encapsulation layer 90 is disposed on the third light-emitting element LE3 and has a third color different from the first color and the second color. In the embodiment, the plurality of light-emitting elements LE1, he plurality of light-emitting elements LE2, and the plurality of light-emitting elements LE3 emitting the same color are each arranged along the direction X, and the light-emitting elements LE1, LE2, and LE3 emitting the different colors are arranged in this sequence along the direction Y. Therefore, the corresponding sub-encapsulation layer 70, the sub-encapsulation layer 80, and the sub-encapsulation layer 90 may each extend along the direction X and be arranged in this sequence in the direction Y, but the disclosure is not limited thereto.

The sub-encapsulation layer 70, the sub-encapsulation layer 80, and the sub-encapsulation layer 90 with different colors can shield the light reflected by the metal layer, thereby improving the contrast of the display device 1l.

In the embodiment, at least two of the adjacent sub-encapsulation layers 70, 80, and 90 (for example, the sub-encapsulation layer 90 and the sub-encapsulation layer 70) at least partially overlap in the normal direction Z, and an overlapping portion has a width w in the direction X, where the width w can be greater than or equal to 2 mm.

In the embodiment, the first surface s1 of the encapsulation layer ML corresponds to the plurality of light-emitting elements LE1, and the second surface s2 of the encapsulation layer ML corresponds to at least part of the space SP between the two adjacent light-emitting elements LE. There is the first difference h between the first surface s1 of the encapsulation layer ML and the second surface s2 of the encapsulation layer ML. The range and the effect of the first difference h can be referred to the above description.

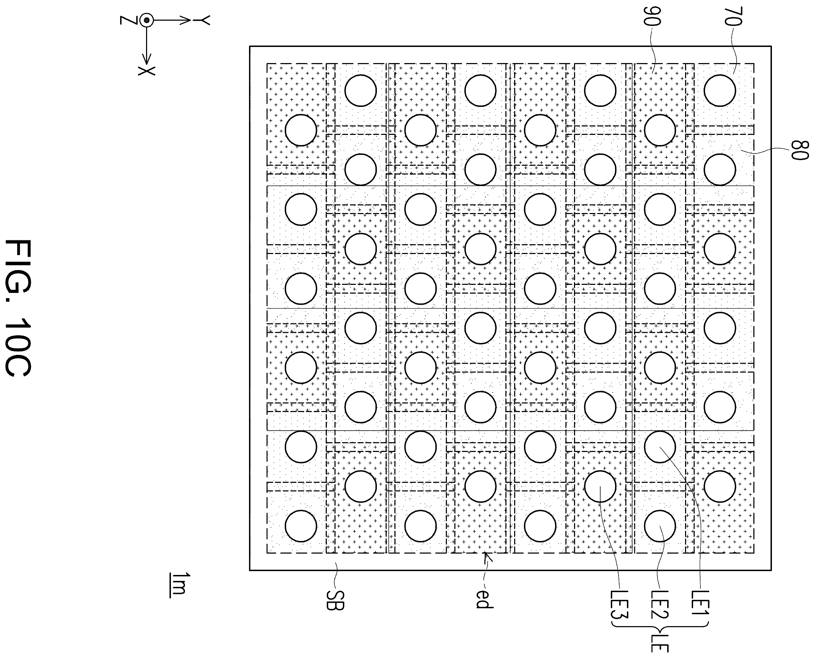

Referring to FIG. 10C, the main difference between a display device 1m and the display device 11 is that the light-emitting elements LE1, LE2, and LE3 emitting different colors are arranged in this sequence along the direction X, and the plurality of light-emitting elements LE1, LE2, and LE3 emitting the same color are arranged alternately in the direction Y. Furthermore, in the embodiment, the plurality of light-emitting elements LE have circular contours in the normal direction Z.

In summary, in the display device and the manufacturing method thereof provided in some embodiments of the disclosure, the surface of the encapsulation layer may have the steps in different areas, presenting an undulating pattern, which helps to increase the surface area of the encapsulation layer. Based on the above, when an intermediate product (for example, an unfinished display device) needs to be moved during the manufacturing process, the protective film can be applied to the surface of the encapsulation layer. Since increasing the surface area of the encapsulation layer can enhance the adhesion of the protective film applied to the encapsulation layer, the problem of the protective film falling off can be reduced, thereby improving the protection effect and/or the yield of the display panel.

## Claims

1. A display device (1, 1a, 1b, 1c, 1d, 1e, 1f, 1g, 1h, 1i, 1j, 1k, 11, 1m), comprising:
a substrate (SB);
a circuit layer (CL), disposed on the substrate (SB);
a plurality of light-emitting elements (LE), disposed on the circuit layer (CL); and
an encapsulation layer (ML), disposed on the substrate (SB) and covers the plurality of light-emitting elements (LE),
wherein the encapsulation layer (ML) has a first surface (s1) and a second surface (s2), the first surface (s1) of the encapsulation layer (ML) is away from the substrate (SB) and corresponds to the plurality of light-emitting elements (LE), and the second surface (s2) of the encapsulation layer (ML) is away from the substrate (SB) and corresponds to at least part of a space (SP) between the two adjacent light-emitting elements (LE),
wherein a first distance between the first surface (s1) of the encapsulation layer (ML) and the substrate (SB) in a normal direction (Z) is different from a second distance between the second surface (s2) of the encapsulation layer (ML) and the substrate (SB) in the normal direction (Z), and a first difference (h, h1, h2, h3, h4, h5, h6, h7, h8, h9, h10) between the first surface (s1) and the second surface (s2) is greater than or equal to 0.4 µm and less than or equal to 25 µm.

2. The display device according to claim 1, wherein the encapsulation layer (ML) comprises:
a first sub-encapsulation layer (30), overlapping the plurality of light-emitting elements (LE) and the at least part of the space (SP) in the normal direction (Z), and having the first surface (s1) and the second surface (s2).

3. The display device according to claim 1, further comprising:
an adhesive layer (OC), disposed on the encapsulation layer (ML), wherein the adhesive layer (OC) has a second difference (H) between the first surface (s1) corresponding to the encapsulation layer (ML) and the second surface (s2) corresponding to the encapsulation layer (ML), and the second difference (H) is smaller than the first difference (h, h1, h2, h3, h4, h5, h6, h7, h8, h9, h10); and
another substrate (CG), disposed on the adhesive layer (OC).

4. The display device according to claim 1, wherein the encapsulation layer (ML) comprises:
a second sub-encapsulation layer (20, 50), overlapping the plurality of light-emitting elements (LE) in the normal direction (Z); and
a third sub-encapsulation layer (30, 40), adjacent to the second sub-encapsulation layer (20, 50) and overlapping the at least part of the space (SP) in the normal direction (Z).

5. The display device according to claim 4, wherein the second sub-encapsulation layer (20, 50) is disposed on the third sub-encapsulation layer (30, 40).

6. The display device according to claim 4, wherein the third sub-encapsulation layer (30, 40) is disposed on the second sub-encapsulation layer (20, 50).

7. The display device according to claim 1, further comprising at least one non-light-transmitting region and at least one light-transmitting region (TR), wherein the at least one non-light-transmitting region surrounds the at least one light-transmitting region (TR), the circuit layer (CL) has at least one opening (OP) corresponding to the at least one light-transmitting region (TR), the plurality of light-emitting elements (LE) correspond to the at least one non-light-transmitting region, and the encapsulation layer (ML) corresponds to the at least one non-light-transmitting region and the at least one light-transmitting region (TR).

8. The display device according to claim 7, further comprising:
a fourth sub-encapsulation layer (40), disposed on the circuit layer (CL), wherein a transmittance of the fourth sub-encapsulation layer is less than or equal to 20%, and the fourth sub-encapsulation layer (40) surrounds the at least one light-transmitting region (TR).

9. The display device according to claim 1, wherein the encapsulation layer (ML) comprises:
a fifth sub-encapsulation layer (70), disposed on a first light-emitting element (LE1) of the plurality of light-emitting elements (LE) and having a first color; and
a sixth sub-encapsulation layer (80), disposed on a second light-emitting element (LE2) of the plurality of light-emitting elements (LE) and having a second color different from the first color,
wherein the fifth sub-encapsulation layer (70) at least partially overlaps the sixth sub-encapsulation layer (80) in the normal direction (Z).

10. The display device according to claim 1, wherein the first difference (h, h1, h2, h3, h4, h5, h6, h7, h8, h9, h10) between the first surface (s1) and the second surface (s2) is greater than or equal to 0.4 µm and less than or equal to 15 µm.

11. A manufacturing method of a display device (1, 1a, 1b, 1c, 1d, 1e, 1f, 1g, 1h, 1i, 1j, 1k, 11, 1m), comprising:
manufacturing a display panel (DP), comprising:
providing a substrate (SB);
forming a circuit layer (CL) on the substrate (SB);
disposing a plurality of light-emitting elements (LE) on the circuit layer (CL); and
forming an encapsulation layer (ML) covering the plurality of light-emitting elements (LE) on the substrate (SB), wherein the encapsulation layer (ML) has a first surface (s1) and a second surface (s2), the first surface (s1) of the encapsulation layer (ML) is away from the substrate (SB) and corresponds to the plurality of light-emitting elements (LE), and the second surface (s2) of the encapsulation layer (ML) is away from the substrate (SB) and corresponds to at least part of a space (SP) between the two adjacent light-emitting elements (LE), wherein a first distance between the first surface (s1) of the encapsulation layer (ML) and the substrate (SB) in a normal direction (Z) is different from a second distance between the second surface (s2) of the encapsulation layer (ML) and the substrate (SB) in the normal direction (Z); and
attaching a protective film (PL) to the encapsulation layer (ML) of the display panel (DP).

12. The manufacturing method of the display device according to claim 11, further comprising:
removing the protective film (PL);
providing another substrate (CG);
forming an adhesive layer (OC) on the encapsulation layer (ML) or the another substrate (CG); and
assembling the display panel (DP) and the another substrate (CG) via the adhesive layer (OC).

13. The manufacturing method of the display device according to claim 11, wherein the display device comprises at least one non-light-transmitting region and at least one light-transmitting region (TR), the at least one non-light-transmitting region surrounds the at least one light-transmitting region (TR), wherein the manufacturing method further comprises:
patterning the circuit layer (CL) to form at least one opening (OP) in the circuit layer (TR), wherein the at least one opening (OP) corresponds to the at least one light-transmitting region (TR), and at least part of the encapsulation layer (ML) is formed in the at least one opening (OP).

14. The manufacturing method of the display device according to claim 12, wherein a first difference (h, h1, h2, h3, h4, h5, h6, h7, h8, h9, h10) between the first surface (s1) and the second surface (s2) is greater than or equal to 0.4 µm and less than or equal to 25 µm, the adhesive layer (OC) has a second difference (H) between the first surface (s1) corresponding to the encapsulation layer (ML) and the second surface (s2) corresponding to the encapsulation layer (ML), and the second difference (H) is smaller than the first difference (h, h1, h2, h3, h4, h5, h6, h7, h8, h9, h10).

15. The manufacturing method of the display device according to claim 12, wherein a thickness of the adhesive layer (OC) is greater than a thickness of the encapsulation layer (ML).
